# EUROPEAN PATENT APPLICATION

(11) **EP 1 914 194 A1**
(43) Date of publication of application: **23.04.2008**
(21) Application number: 06021785.8
(22) Date of filing: 18.10.2006
(51) Int. Cl.: B81B 3/00

(54) **Device for converting a first motion into a second motion responsive to said first motion under a demagnification scale**

(71) Applicant: Paul Scherrer Institut PSI, 5232 Villigen PSI (CH)
(72) Inventor: Henein, Simon, Dr., 2000 Neuchâtel (CH)
(74) Representative: Fischer, Michael

(57) **Abstract**

The present invention discloses a device (CD) for converting a first motion (xₛ) into a second motion (Δy) responsive to said first movement (xₛ) under a demagnification scale (i), comprising:
a) an input portion (IP) being drivable in a rectilinear translation in a first direction (x) by an actuator (AC) causing said first motion (xₛ);
b) an output portion (OP) being movable by a converting blade (CB) causing said second motion (Δy) responsive to said first motion (xₛ) in a second direction (y) substantially perpendicular to said first direction (x); and
c) a converting section (CS) connecting said input portion (IP) to said output portion (OP); said converting section (CS) comprising an intermediate spring portion (ITP) and the converting blade (CB),
c1) wherein said intermediate spring portion (ITP) comprises at least two parallel flexure blades (FB1, FB2); and
c2) wherein said converting blade (CB) being substantially identical in shape to the a least two parallel flexure blades (FB1, FB2) and being offset from its neutral position by a predetermined amount (x₀) in the first direction (x) as compared to the neutral position of the at least two parallel flexure blades (FB1, FB2).

This device has a flexure-based structure that allows combining the advantages of classical actuators with accuracies in the micrometer range and the advantages of flexures to achieve nanometer accuracy.

## Description

The invention relates to a device for converting a first motion into a second motion responsive to said first motion under a demagnification scale.

The aforementioned device can be considered as a gearbox converting a significantly larger first motion into a demagnified second larger motion. The demand for motion precisions better that 0.1 micrometer is growing in many fields of science and technology (e.g. manipulation tools for nanotechnology, manufacturing and assembly tools for silicon technology (chips and Micro-(Opto)-Electro-Mechanical System (MEMs and MOEMs) production). Achieving such motion accuracies implies severe challenges both in terms of actuation and bearing.

These difficulties result from the unavoidable physical limitations of the traditional actuator and bearing technologies that both generally rely on rolling or sliding bearing elements (ball-bearings, lead screws, etc.). The inherent presence of friction and the associated hysteresis and non linear behavior today limits standard motion system to typically 0.1 micrometer accuracy. To go beyond this barrier, novel technologies must be used: for actuation, piezoelectric actuators are today widely used and for the bearings, flexures have become a standard. This piezo/flexure combination has bear fruit for many applications at nanometer level; it has nevertheless a major drawback which is the associated complex and expensive driving electronics and controller. I.e. piezo require high voltages to be driven and are generally used in conjunction with position feedback sensors because their behavior is non-linear and present hysteresis and drifts. Compared to traditional stepper or DC motors, piezos are much more difficult and expensive to drive.

It is further well known in the state-of-the-art that flexures can be used as a demagnification kinematic chain, but the solutions having an important demagnification ratio (typically between 1:20 and 1:1000) known until today all have a non-linear behavior, i.e. the demagnification factor is not constant over the motion range.

It is therefore the aim of the present invention to provide a device having a motion accuracy better than 0.1 micrometer and being significantly easier in controlling due to the absence of drift and/or hysteresis and/or non-linear behaviour.

This aim is achieved by a device for converting a first motion into a second motion responsive to said first motion under a demagnification scale, comprising:
a) an input portion being drivable in a rectilinear translation in a first direction by an actuator causing said first motion;
b) an output portion being movable by a converting blade causing said second motion responsive to said first motion in a second direction substantially perpendicular to said first direction; and
c) a converting section connecting said input portion to said output portion; said converting section comprising an intermediate spring portion and the converting blade,
c1) wherein said intermediate spring portion comprises at least two parallel flexure blades; and
c2) wherein said converting blade being substantially identical in shape to the a least two parallel flexure blades and being offset from its neutral position by a predetermined amount in the first direction as compared to the neutral position of the at least two parallel flexure blades.

This device has a flexure-based structure that allows combining the advantages of classical actuators with accuracies in the micrometer range and the advantages of flexures to achieve nanometer accuracy. The device is therefore able to convert microns into nanometers in the same way as reduction gearboxes demagnify the angular motion of a classical motors. In the case of the present device both the input and output motions are linear (translations) and not rotational like in the case of a gearbox. The actual motion demagnification results from the differential shorting of the converter blade with respect to the blades of the parallel spring portion when those blades are deformed in a natural S shape. This shorting is parabolic, i.e. proportional to the square of the motion range. Thus, the device is subtracting two identical parabolic motions that are offset by a determined amount which the converting blade is offset relative to the two parallel flexure blades. One can mathematically derive that the resulting motion is a linear demagnification of the input motion, where the demagnification factor is simply: *i = 5*L* / *(6* xₒ)*, where L is the length of the blades of the parallel spring portion and of the converting blade, and *xₒ* the offset of the converting blade relative to the two parallel flexure blades. Due to the subtraction of the two identical parabolic motions, the demagnification is constant over the full stroke of the mechanism: the device is purely linear.

With respect to a design of the device, a suitable structure provides the at least to parallel flexure blades and the converting blade sharing a common base. Thereby, all blades are driven to the same extent into the first direction (responsive to the first motion), whereby the converting blade is bridging the common base and the output portion.

The design of the blades have a relevant impact on the motions achieved. Therefore, the shape of the blade is chosen in a way that both the intermediate spring portion and the output portion move on a parabolic trajectory in response to the first motion. As an outcome of this measure a ratio of the length 1 to the thickness of the blades shall be much larger than 1. Another outcome is that the ratio of the length 1 of the blades to the determined offset x₀ shall be much larger than 1, too.

In a preferred embodiment of the present invention the device is manufactured monolithically, i.e. by wire electro-discharce machining, laser cutting, silicon edging, Therefore, the device does not comprise any parts to be assembled which again has an advantagous impact on the removal of unintended sources of drift and hysteresis.

The device has been developed for an optical instrument to be used on at least two beamlines of the Swiss Light Source synchrotron: TOMCAT (Tomographic Microscopy and Coherent Radiology Expertiment) and cSAXS (Coherent Small Angle X-ray Scattering). The optical instrument is a Differential Phase Contrast (DPC) Interferometer that can be mounted on standard absorption setups to observe phase shift information. This instrument consists in two optical gratings with pitches of a few microns. One of the gratings must be scanned with a precision of the order of 20 nanometers over a range of typically 30 microns during the x-ray exposure. This device has been designed to perform this scanning motion, using a commercial "pusher" (stepper motor with lead screw and nut, driving an output shaft axially).

Preferred embodiments of the present invention are described hereinafter in detail by referring to the following drawings:
Figure 1 illustrates the working principle of a converter device.
Figure 2 shows a view on the converter device according to Fig. 1.
Figure 3 depicts an example of a setup of a Differential Phase Contrast-Interferometer on the Tomcat beamline sample mover.
Figure 4 shows the motion characteristic of the converter device according to Figures 1 and 2.
Figure 5 illustrates the graph of the demagnification factor as a function of the offset of a converter blade.

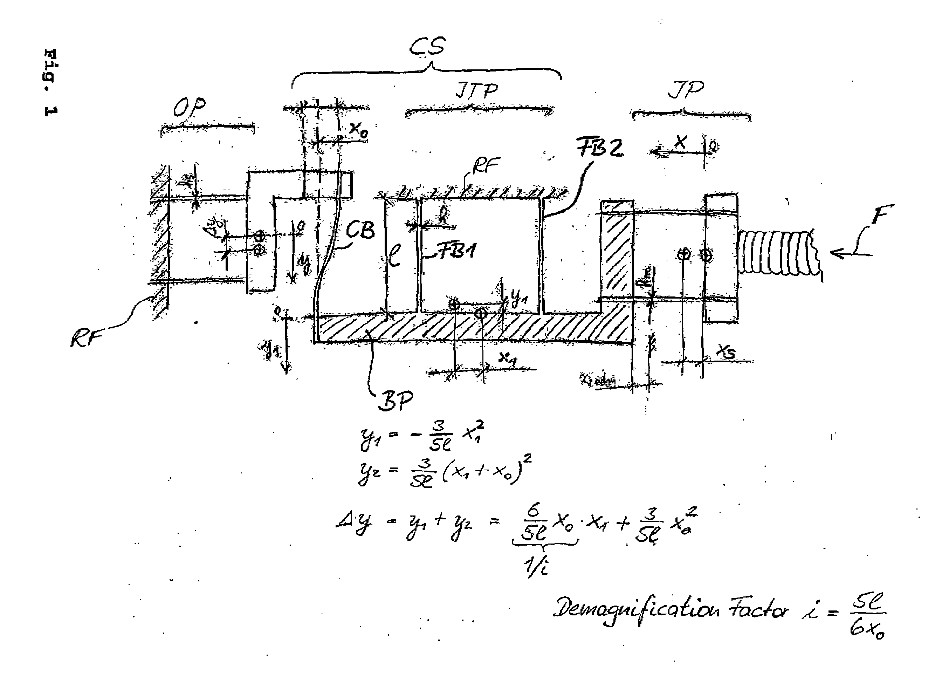

Figure 1 illustrates the working principle of a converter device CD according to the present invention. The motion demagnification factor i is constant over the full motion range (i.e. the movement conversion is linear). "i" is inversely proportional to an offset *xₒ* of a converter blade CB which allows the selection (or tuning if this offset is designed to be tunable) by playing on a single geometrical parameter of the strucutre: *i = 5*l* / *(6* xₒ)*; wherein l is the length of the converter blade and two flexure blades FB1, FB2 in an intermediate portion ITP of the device CD. The intermediate portion ITP forms together with the converting blade CB a converting stage CS.

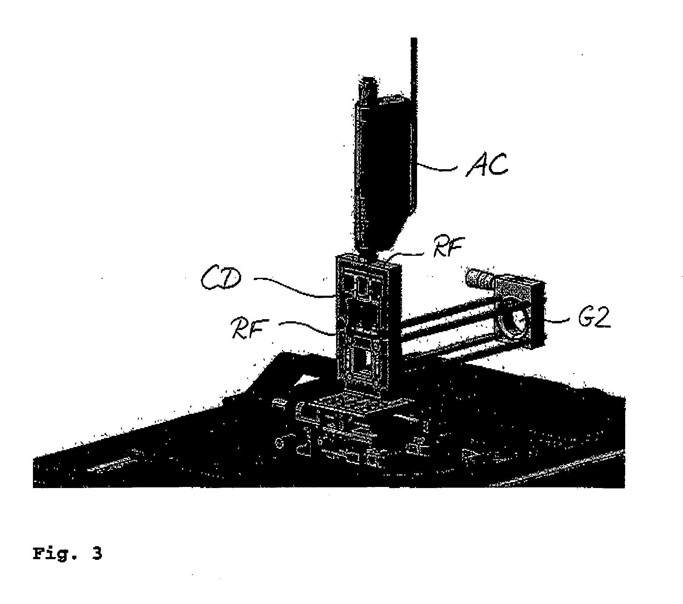

The working principle of the converter device CD is rather simple. The converter device CD comprises a rigid frame RF to which the actuator AC is fixed (see Figure 3). For an input of a first motion xₛ in a first direction, hereinafter referred to as x-direction, an input portion IP comprising a parallel spring stage driven in rectilinear translation by the actuator AC with a coarse (typically micrometric) precision is provided. The intermediate portion ITP comprises an intermediate parallel spring stage having the two identical parallel flexure blades FB1 and FB2. The two flexure blades FB1, FB2 share with the converting blade CB a common base portion BP. The converting blade CB that is identical to the two flexure blades FB1, FB2 of the parallel spring stage is deflected from its neutral position (position where the blade is straight) in term of an offset by a certain amount *xₒ* with respect to the neutral position of the two flexure blades FB1, FB2 of the parallel spring stage. This offset defines the demagnification factor, beside the length 1 of the blades FB1, FB2, CB. The converting blade CB is thereby bridging the base portion BP and an output portion OP. This output portion OP is designed as an output parallel spring stage driven in translation in y-direction with fine (typically nanometric) precision by the converting blade CB.

The motion demagnification results from the differential shorting of the converting blade CB with respect to the two flexure blades FB1, FB2 of the parallel spring stage when those blades FB1, FB2 are deformed in a natural S shape. This shorting is parabolic, i.e. proportional to the square of the motion range in x-direction. That means that the base portion BP is transferred with an amount x₁ in x-direction and an amount y₁ in negative y-direction responsive to a first coarse motion xₛ in x-direction. Also the converting blade CB has to follow this motion with x₁ and y₁, but as it was already deflected by x₀ on its parabolic trajectory, it moves on a different section of this parabolic trajectory as compared to the two flexure blades FB1, FB2. Thus, the converter device CD is subtracting two identical parabolic motions that are offset by an amount *xₒ*. One can mathematically derive that the resulting motion is a linear demagnification of the input motion, where the demagnification factor is simply: *i* = *5*l* / *(6* xₒ),* where 1 is the length of the two flexure blades FB1, FB2 of the parallel spring stage and of the concerting blade CB, and *xₒ* the offset of the converting blade CB (see Figure 1 for detail mathematical description of the motion). This demagnification is constant over the full stroke of the device mechanism; the system is purely linear.

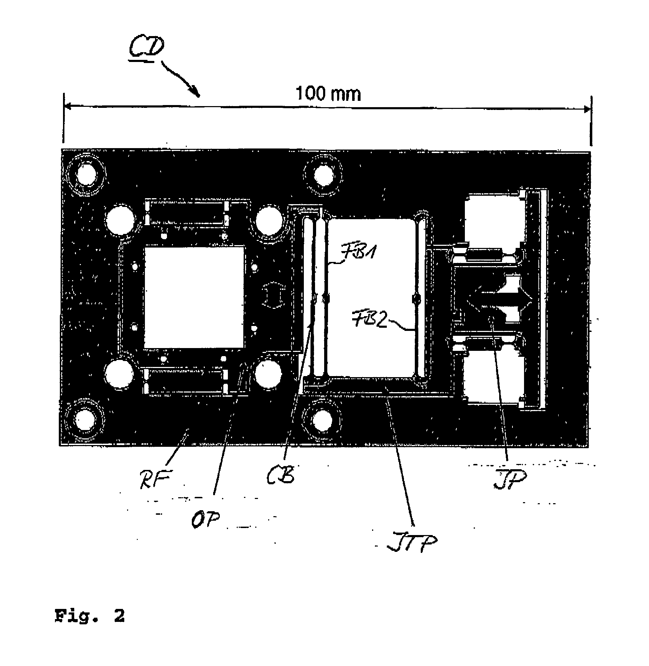

Figur 2 now illustrates a typical design of the converter device CD. This examplatory device is designed for a Phase Contrast Interferometer mentioned in the introduction. This design has a fixed demagnification factor of 1:100. The input motion range is +/- 1.4 mm and the respective output motion range is therefore +/- 14 microns. The accuracy of the selected commercial actuator AC is +/-1 microns, and the respective output resolution is therefore +/- 10 nm. The converting blade CB has a length of 30 mm and an offset of 0.25 mm. The overall size on the device CD is 100 x 50 x 10 mm. This version of the device CD was designed in order to be compatible with the commercial Linos standard optical elements (Linos Micro-bench). This structure is manufactured monolithically by wire-EDM in Stainless Steel (Böhler W720). The device can also be machined with a wide variety of techniques to be adapted to various application fields (e.g. wire electro-discharge machining (EDM), laser cutting, silicon etching, LIGA, etc.)

Figure 3 illustrates the converter device CD assembled into the Phase Contrast Interferometer. The device CD is dedicated to hold the first grating (not shown) of the interferometer and is driven by a commercial pusher AC as actuator. The second grating G2 of the interferometer is mounted on a standard Linos rotation unit.

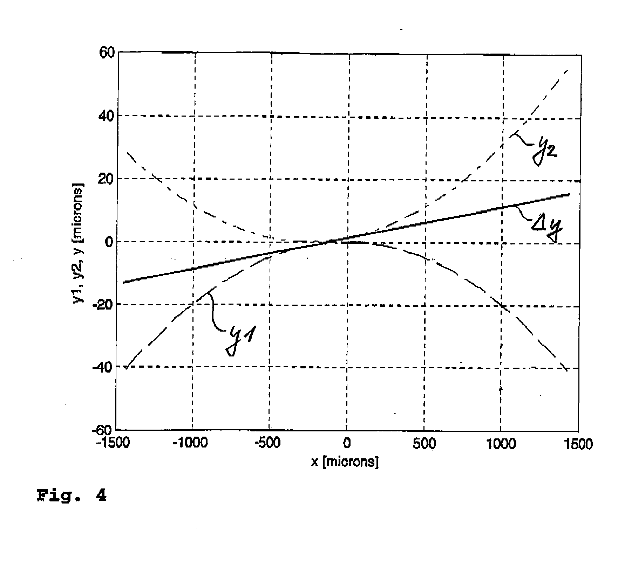

Figure 4 illustrates by means of threes curves the kinematics of the converter device CD. The first curve is the shorting of the two flexure blades FB1, FB2 of the parallel spring stage (y₁), the second curve is the shorting of the concerting blade CB (y₂), and the third third is the motion of the output stage (Δy) as a function of the motion of the actuator AC in x-direction. The subtractions of the two identical parabolas that are slightly shifted by the offset x₀ lead to a linear characteristic of the resulting motion in y-direction (the constant slope of the (Δy)-curve means that the demagnification factor is constant).

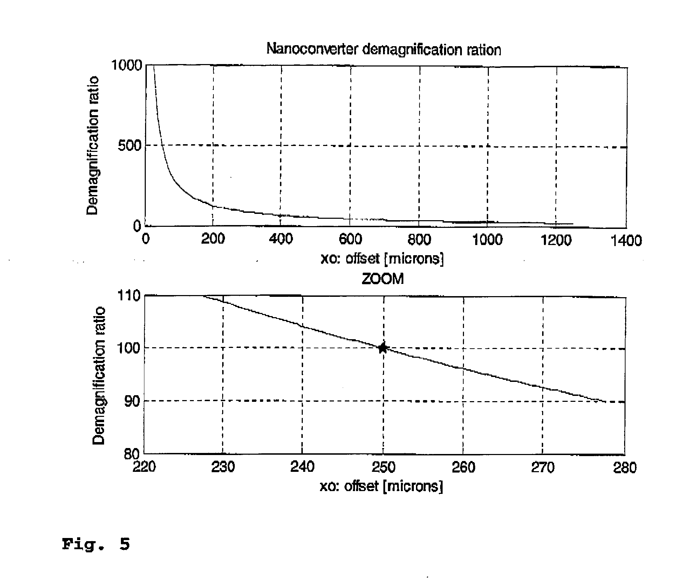

Figure 5 illustrates the graph of the demagnification factor as a function of the offset of the converter blade CB. By varying the offset x₀ between 25 and 1250 microns, the demagnification factor can be tuned between 1:20 and 1:1000. In the particular case of this design, a fixed demagnification factor of 1:100 has been selected, which corresponds to an offset x₀ = 250 microns. This working point is shown as a little star on the bottom graph (this graph in an enlargement of the upper graph).

As explained to the Figures 1 to 5, in comparison to the state-of-art solutions the converter device CD presents the following key advantages:
- Linear behavior (i.e. constant demagnification factor over the full motion range);
- very high demagnification factors achievable (typically up to 1:1000);
- Tunable devices where a simple tuning screw or shim allows selecting the demagnification factor over a wide range (typically 1:20 to 1:1000) can be designed;
- Simple planar structure that can be manufactured monolithically (no need for assembly).

## Claims

1. Device (CD) for converting a first motion (xₛ) into a second motion (Δy) responsive to said first movement (xₛ) under a demagnification scale (i), comprising:
a) an input portion (IP) being drivable in a rectilinear translation in a first direction (x) by an actuator (AC) causing said first motion (xₛ) ;
b) an output portion (OP) being movable by a converting blade (CB) causing said second motion (Δy) responsive to said first motion (xₛ) in a second direction (y) substantially perpendicular to said first direction (x); and
c) a converting section (CS) connecting said input portion (IP) to said output portion (OP); said converting section (CS) comprising an intermediate spring portion (ITP) and the converting blade (CB),
c1) wherein said intermediate spring portion (ITP) comprises at least two parallel flexure blades (FB1, FB2); and
c2) wherein said converting blade (CB) being substantially identical in shape to the a least two parallel flexure blades (FB1, FB2) and being offset from its neutral position by a predetermined amount (x₀) in the first direction (x) as compared to the neutral position of the at least two parallel flexure blades (FB1, FB2).

2. Device according to claim 1, wherein the at least to parallel flexure blades (FB1, FB2) and the converting blade (CB) share a common base (BP) and are driven therefore to the same extent into the first direction (x), whereby the converting blade (CB) is bridging the common base (BP) and the output portion (OP).

3. Device according to claim 1 or 2, wherein both the intermediate spring portion (ITP) and the output portion (OP) move on a parabolic trajectory in response to the first motion (xₛ).

4. Device according to any of the preceding claims, being manufactured monolithically, i.e. by wire electro-discharce machining, laser cutting, silicon edging.
